(19) Europäisches Patentamt
European Patent Office
Office européen des brevets

(11) EP 2 157 604 A1

(12) **EUROPEAN PATENT APPLICATION**
published in accordance with Art. 153(4) EPC

(43) Date of publication:
**24.02.2010 Bulletin 2010/08**

(21) Application number: **08764748.3**

(22) Date of filing: **27.05.2008**

(51) Int Cl.:
***H01L 21/822*** *(2006.01)*
***H01L 27/04*** *(2006.01)*
***H01L 49/00*** *(2006.01)*
***H01L 51/30*** *(2006.01)*
***G06N 3/063*** *(2006.01)*
***H01L 45/00*** *(2006.01)*
***H01L 51/00*** *(2006.01)*

(86) International application number:
**PCT/JP2008/059720**

(87) International publication number:
**WO 2008/152908 (18.12.2008 Gazette 2008/51)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **14.06.2007 JP 2007156982**

(71) Applicant: **Sony Corporation**
**Tokyo 108-0075 (JP)**

(72) Inventors:
- **MATSUMURA, Hajime**
  **Tokyo 108-0075 (JP)**
- **MATSUI, Eriko**
  **Tokyo 108-0075 (JP)**

(74) Representative: **Müller - Hoffmann & Partner**
**Patentanwälte**
**Innere Wiener Strasse 17**
**81667 München (DE)**

# (54) RESISTIVE ELEMENT, NEURON ELEMENT, AND NEURAL NETWORK INFORMATION PROCESSING APPARATUS

(57) In a neuron element (1) having an input part (10) that receives a plurality of input signals xi and, in response to the respective input signals, creates weighted signals xiwi as the products of the input signals and connection weights wi corresponding to the input signals, an addition part (20) that obtains the total sum X of the plurality of weighted signals xiwi (i = 1 to n), and an output part (30) that outputs an output signal Y(X) as a function of the total sum X, a functional molecular element (11) having a current-voltage characteristic in which the current flowing through the element is represented as a function having an inflection point with respect to the applied voltage is used as an element that defines the output signal Y(X), and the output signal Y is defined as a function of the total sum X based on the current-voltage characteristic of this element in the region including the inflection point. Thereby, a neuron element that includes an output part formed of a simple circuit and has an analogous output characteristic, and a neural network information processing device employing it are provided.

FIG. 1

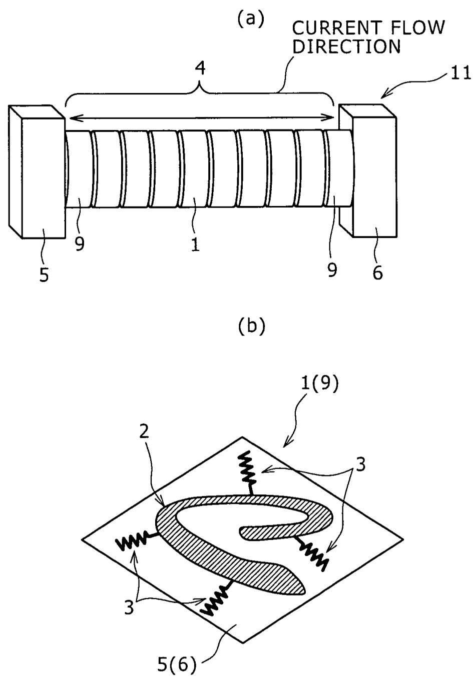


EP 2 157 604 A1

## Description

### Technical Field

The present invention relates to a resistive element, a neuron element including the resistive element in an input part, and a neural network information processing device employing the neuron element, and specifically relates to hysteresis exhibited by the resistive element.

### Background Art

The nanotechnology is a technique for observation, fabrication, and utilization of a microstructure whose size is about $10^{-8}$ m (= 10 nm). The scanning tunneling microscope has been invented in the late 1980s, and thus not only observation of atoms and molecules but also operation of atoms and molecules on a one-by-one basis has become possible. For example, an example in which atoms are arranged on a surface of a crystal to write a character has been reported.

However, although having said that atoms and molecules can be operated, it is impractical to construct new material and device by operating a huge number of atoms and molecules one by one. To form the intended structural body by operating atoms, molecules, and groups thereof, a new processing technique enabling it is necessary. As such a processing technique for the molecular level, a bottom-up system is attracting attention. In the bottom-up system, atoms, molecules, and groups thereof are used to resemble parts and these parts are assembled into a structural body by a method such as self-assembly.

Studies to fabricate a nanometer-size structural body by the bottom-up system are being made also regarding metals, ceramics, and semiconductors. However, molecules are each independent and have a variety including several million kinds based on shape differences, function differences, and so on. Therefore, it is expected that molecular devices having characteristics entirely different from those of conventional devices can be fabricated if the variety is used.

For example, the width of an electrically-conductive molecule is only 0.5 nm. This molecular wire material can realize an interconnect having high density that is higher by a factor of several thousand compared with a line width of about 100 nm, which is realized in the present integrated circuit technique. Furthermore, for example, if one molecule is used as a memory element, recording density higher than that of the DVD by a factor of ten thousand or larger is possible.

In 1986, Hiroshi Koezuka at Mitsubishi Electric Corporation developed the world's first organic transistor composed of polythiophene (polymer). Thereafter, studies are being actively made on molecular devices having various functions, such as organic thin film transistors, molecular switches, molecular logic circuits, and molecular wires.

One of the problems of the molecular device is that the connection part between the constituent molecules and the electrode has high electric resistance and this high resistance restricts the characteristics of the molecular device. For example, in an organic field effect transistor, carrier movement in organic molecules in the channel region is modulated by change in an electric field acting on the organic molecules. In this transistor, the contact resistance across the interface between the constituent molecules and the electrode is very high and this contact resistance intensely affects the operating characteristics of the transistor.

Furthermore, one of the present inventors has proposed a functional molecular element based on a new principle in Japanese Patent Laid-Open No. 2004-221553. This molecular element functions as a molecular switch that changes the molecular structure based on the effect of an electric field and turns ON and OFF a current. Also in this molecular element, if the contact resistance across the interface between the constituent molecules and the electrode is high, this contact resistance affects the operating characteristics of the molecular element.

In addition, also in the case in which molecular layers for allowing the flow of electrons are disposed between opposed electrodes, such as in an organic solar cell, it is required that the contact resistance across the interface between organic molecules and the electrode is set as low as possible.

Thus, one of the present inventors has proposed a functional molecular element having a novel structure that allows decrease in the contact resistance across the interface between the constituent molecules and the electrode, a method for manufacturing the same, and a functional molecular device in Japanese Patent Laid-Open No. 2006-351623 (pp. 11 to 15, FIGS. 1 to 5).

This functional molecular element is e.g. a functional molecular element in which
a n-conjugated molecule in which a side chain part is coupled to a backbone part having a planar or substantially-planar structure formed of a n-conjugated system is absorbed by an electrode at the side chain part, to thereby form an absorbed molecule that is so disposed that the planar or substantially-planar structure of the backbone part is in substantially parallel to the electrode, and
a structural body composed of at least the absorbed molecule and the electrode has a function to allow a current to flow in a direction intersecting with the planar or substantially-planar structure.

On the other hand, the von Neumann computer has achieved great development based on the semiconductor

technique of fabricating a micro semiconductor chip on a semiconductor wafer by lithography, etching, and so on. However, in recent years, it has become clear that there are fields at which the von Neumann computer is no good, such as pattern recognition. In these fields, the neuro-computer imitating the creature's brain is attracting attention.

The creature's brain is formed with complicated coupling of a large number of nerve cells (neurons) in a network manner ("Nou no Keisan Riron," Mitsuo Kawato, Sangyo Tosho, 1996).

FIG. 7 is a schematic explanatory diagram showing the configuration of a nerve cell 100. The nerve cell 100 is composed of a cell body 101, dendrites 102, an axon 103, nerve terminals 104, synapses 105, and so on. The cell body 101 includes a nucleus 101a and so on and is the main body part of the nerve cell 100. The dendrites 102 have a structure like a large number of branches extending from the cell body 101 and are parts equivalent to input terminals of the nerve cell 100. The axon 103 has a structure with a shape of one long, thick funiculus extending from the cell body 101 and is the part that generates the output of the nerve cell 100. The tip thereof is branched into plural paths to form the nerve terminals 104 that send signals to other output-side nerve cells 109.

The synapse 105 is a coupling part that interconnects a nerve cell and a nerve cell. Input signals 107 from other input-side nerve cells 106 are transmitted to the nerve cell 100 via input-side synapses 105a between the nerve terminals of the input-side nerve cells 106 and the dendrites 102 and the cell body 101 of the nerve cell 100. Furthermore, output signals 108 from the axon 103 of the nerve cell 100 are transmitted to the output-side nerve cells 109 via output-side synapses 105b between the nerve terminals 104 and the dendrites and the cell bodies of the nerve cells 109.

For example, in the human brain, one nerve cell 100 can receive the input signals 107 from the input-side nerve cells 106 via several thousand or more synapses 105a. The nerve cell 100 executes information processing for this large number of input signals 107 and outputs the result to a large number of output-side nerve cells 109 from one axon 103.

The signal transmission between nerve cells via the synapses 105 is carried out based on potential change. The operation of the nerve cells at the time will be described below by taking excitation generation as an example. Specifically, if the potential of the liquid outside the nerve cell 100 is defined as the reference potential, the membrane potential of the cell membrane of the axon 103 is generally kept at a negative potential (resting potential) of about -60 mV. In response to reception of the input signals 107 by the nerve cell 100 from the input-side nerve cells 106 via the synapses 105a, the membrane potential of the axon 103 rises up. The potential rises due to the respective input signals 107 are added to each other. If the sum of the potential rises due to a large number of input signals 107 surpasses the threshold (potential higher than the resting potential by about 15 mV), the axon 103 generates the output signal 108 with a height of about 115 mV and a duration of about 0.5 ms at that moment. The output signal 108 is sent from the nerve terminals 104 to the output-side nerve cells 109 via the synapses 105b.

As described above, the signal transmission between nerve cells is carried out by a pulse voltage having a substantially-constant waveform, and the number of pulses per unit time is large when the brain activity is strong. On this occasion, the signal transmission is necessarily carried out via the synapses 105. For example, the cell body of the output-side nerve cell 109 receives not the output signal 108 itself but a pulse resulting from the change by the synapse 105b as a signal. Therefore, depending on the difference in the signal transmission characteristic of the synapse 105b, the differences of the following (1) to (4) arise in the effect of the output signal 108 in the output-side nerve cell 109.

(1) whether the signal is excitatory or inhibitory
(2) the magnitude of the voltage change caused by the signal
(3) the duration of the effect caused by the signal
And, as a result,
(4) whether the signal yields a learning effect.

In this manner, the relationship between nerve cells depends on whether or not the synapse coupling is present and the signal transmission characteristic of the synapse. Although one nerve cell has only a simple function, the human brain includes ten billion or more nerve cells. A large number of cells of these nerve cells simultaneously operate in parallel to execute distributed processing, which allows exertion of high information processing ability. Furthermore, a learning effect is exerted by formation of synapse coupling and change in the signal transmission characteristic of the synapse.

A neural network (nerve circuit network) is an information processing circuit network imitating the above-described characteristics of the information processing in the brain, and is formed of neuron elements imitating nerve cells (neurons) (Neural Net no Kiso to Ouyou, Norio Baba, Fumio Kojima, Seiichi Ozawa, Kyoritsu Shuppan Co., Ltd. (1994), Jissen Neural Net, Takeo Miyazawa, monthly ASCII, Vol. 12, the September 1988 issue, p. 237 to Vol. 13, the April 1989 issue, p. 341). The neuro-computer is a computer that is formed of the neural network and characterized in parallel distributed processing.

FIG. 8(a) is a schematic explanatory diagram showing the functions of the neuron element in a model manner. As shown in FIG. 8(a), a neuron element 200 is composed of an input part 210, an addition part 220, and an output part 230.

The input part 210 corresponds to the function of the synapse 105. In response to the respective input signals xi (i = 1 to n) from other neuron elements, the input part 210 creates weighted signals wixi (i = 1 to n) as the products of the input signals xi and connection weights wi (i = 1 to n) corresponding to the inputs. The connection weight wi corresponds to the signal transmission characteristic of the synapse 105.

The addition part 220 corresponds to the function of the cell body 101. The addition part 220 obtains the total sum (net value) X of the weighted signals wixi, defined by the following equation for all of the input signals xi (i = 1 to n), and outputs it to the output part 230.

$$X = w1x1 + w2x2 + \cdots + wnxn$$

The total sum (net value) X corresponds to the rise of the axon potential due to the input signals.

With this model, it can be expressed that the input-side neuron element giving the input signal xi has larger influence on the neuron element 200 when the connection weight wi is set larger. Furthermore, it can be expressed that the neuron element giving the input signal xi has no effective influence on the neuron element 200 when the connection weight wi is set to zero, and it can be expressed that the neuron element giving the input signal xi has inhibitory influence on the neuron element 200 when the connection weight wi is set negative.

The output part 230 defines an output signal Y(X) as a function of the total sum (net value) X and outputs it. FIG. 8(b-1) shows an example in which the output function Y(X) is a threshold type function (step function) including θ as the threshold. This is the function employed when McCulloch and Pitts modeled the operation of the nerve cell first time and defined the formal neuron as a multi-input one-output function. The output part 230 outputs

$$Y = 0 \text{ if } X < \theta$$

$$Y = 1 \text{ if } X = \theta \text{ or } X > \theta.$$

FIG. 8(b-2) shows an example in which the output function Y(X) is a sigmoid function represented by the following equation.

$$Y = 1/(1 + \exp(-aX))$$

The sigmoid function is a function that has a nonlinear characteristic with respect to the input X but monotonically increases from zero to one in linkage with increase in X. Symbol a in the equation is a parameter that determines the steepness of the slope of the function, and larger a brings the function Y closer to a step function. Furthermore, if the above equation is changed to the following equation, the threshold θ can be introduced in the sigmoid function.

$$Y = 1/(1 + \exp(-a(X - \theta)))$$

Combining a plurality of the above-described neuron elements 200 enables logical operation, and a neural network can be formed by connecting a large number of neuron elements 200. In this case, the structure and characteristics of the network depend on the way of the connection of the neuron elements. The neural network is roughly categorized into a hierarchical network and an interconnected network, depending on the network structure.

FIG. 9(a) is an explanatory diagram showing one example of the hierarchical neural network. This example is an example in which a hierarchical neural network 300 is composed of three layers of an input layer 310, an intermediate layer 320, and an output layer 330. Input signals are applied to neuron elements 301 in the input layer 310, and output signals in response to the input signals are brought out from the neuron elements 301 in the output layer 330. Like this example, the hierarchical neural network is formed by disposing the neuron elements 301 in plural layers and the neuron elements 301 are coupled to each other between the layers, and the signals are transmitted from layer to layer in only one direction from the input layer 310 toward the output layer 330.

In the hierarchical neural network, achievement of a more preferred output signal is permitted by changing the connection weights wi of the respective neuron elements and the threshold θ of the output function based on the error between an actual output signal in response to a certain input signal and the desired output signal. This is a learning function possessed by the hierarchical neural network. Because the hierarchical neural network has such a learning

function, it is effectively applied to pattern recognition by PDP (Parallel Distributed Processing), such as image recognition, character recognition, and audio recognition, at which the von Neumann computer is no good, and various fields in which autonomous learning is required.

In this case, it is known that the learning and discrimination ability is dramatically enhanced if a neuron element whose output function Y(X) is not a step function but an analogous sigmoid function is used as the neuron element 301 included in the hierarchical neural network 300. Furthermore, it is known that a back propagation method or the like is effective as the learning algorithm.

FIG. 9(b) is an explanatory diagram showing a Hopfield network as one example of the interconnected neural network. In a Hopfield network 400, all of neuron elements 401 are coupled to each other to form one layer. Therefore, the direction of the signal flow is not one direction, but feedback of the signal to each other is carried out.

In the Hopfield network 400, a connection weight wij is fixed as a parameter in modeling of the system, and autonomous learning is not carried out in the calculation process. However, it is said that the value of each neuron element 401 converges on the optimum value if the connection weight wij is so set that wij = wji is satisfied. The connection weight wij is the connection weight for the input to the i-th neuron element 401 from the j-th neuron element 401 (in FIG. 9(b), the numeral in the rectangle indicating a connection weight wij 402 is ij as the combination of i and j). The Hopfield network is applied to the field of associative memory and a field in which an analogous approximate solution is obtained for a combinatorial optimization problem such as the traveling salesman problem, inverse matrix calculation, or the like, which involves many variables and is impossible for the von Neumann computer to calculate.

In studies on the neural network, the von Neumann computer is used as hardware and simulation of the operation thereof is performed by software in many cases. However, with this configuration, high-speed performance of the neural network as a parallel analog network can not be really utilized. Therefore, to put a neural network information processing device into practical use, it is required to employ electronic circuits as the respective parts of the neuron element 200.

Thus, an element obtained by coupling neuron elements to each other via an EEPROM (Electrically Erasable Programmable Read-Only Memory), which is a nonvolatile memory, has been proposed as a neuron element in Japanese Patent Laid-Open No. Hei 3-144785 (pp. 2 to 4, FIGS. 1 to 3). In this neuron element, the respective input signals to the neurons are multiplied by coefficients that are held by the amount of charge accumulated in the trap of the EEPROM or the amount of charge accumulated in the floating gate and correspond to the weights that should be each given to a respective one of the signals.

Disclosure of Invention

FIG. 10 is an explanatory diagram showing one example of the configuration of an input part and an addition part in a conventional neuron element. As shown in FIG. 10, input circuits 511 equivalent to synapses are provided in an input part 510. In response to the respective input signals xi (i = 1 to n) from other neuron elements, the input circuits 511 create weighted signals wixi (i = 1 to n) as the products of the input signals xi and connection weights wi (i = 1 to n) corresponding to the inputs. The connection weight wi corresponds to the signal transmission characteristic of the synapse.

Specifically, the input signal xi (i = 1 to n) is applied to the source electrode of a transistor 512 of the input circuit 511 as a voltage signal. A gate voltage corresponding to the connection weight wi is applied to a gate electrode 513 of the transistor 512 by the operation of a memory circuit, whose diagrammatic representation is omitted. As a result, the electrical conductivity of the transistor 512 is controlled by the gate voltage, so that a current signal equivalent to the weighted signal wixi is sent from the drain electrode of the transistor 512 to an addition part 20.

As shown in FIG. 10, the addition part 20 is a current-voltage conversion circuit formed of an OP amp (operational amplifier) 21. The output currents from the respective input circuits 511 in the input part 510 are collected into the inverting input terminal of the OP amp 21 and flow from a feedback resistor 22. Thereby, a voltage signal corresponding to the total sum (net value) X defined by the following equation is output to an output circuit 30.

$$X = w1x1 + w2x2 + \cdots + wnxn$$

In the above-described neuron element, the gate voltage corresponding to the connection weight wi needs to be held, and therefore the memory circuit, voltage generation means, and so on, whose diagrammatic representation is omitted, are necessary. A large number of neuron elements need to be integrated for forming a neural network. Considering that a much larger number of connection weights than the neuron elements are included in the neuron elements, the configuration of the above-described neuron element is impractical.

In the context of this, the coupling of neuron elements via an EEPROM, which is a nonvolatile memory, has

been proposed in Japanese Patent Laid-Open No. Hei 3-144785 (pp. 2 to 4, FIGS. 1 to 3). However, the EEPROM involves a problem that memory is damaged and the long-term memory characteristic becomes insufficient along with thermal hysteresis. For example, the analog-value memory performance of the EEPROM is about four bits due to the thermal hysteresis, and this is insufficient to accurately set the connection weight (refer to Japanese Patent Laid-Open No. Hei 5-12466).

Furthermore, "the more the creature's brain is used, the wiser it becomes." Specifically, the creature's brain has such a learning function that, if a signal passes through the same synapse many times, the characteristics of the synapse are so gradually changed that the synapse comes to allow the passage of the signal therethrough more easily. On the other hand, the EEPROM is a memory element that stores the peak voltage, and the memory thereof does not change even when a voltage with the same magnitude is repeatedly applied thereto. That is, the EEPROM does not have the function to store "repetition." Therefore, the memory element that stores the peak voltage, such as the EEPROM, can not realize the learning function possessed by the creature's brain.

In addition, although related to the above description, a method for giving an autonomous learning function to an interconnected neural network such as a Hopfield network has not yet been established. As described above, it is apparent that any breakthrough is necessary to give the autonomous learning function to a neural network with a simple configuration.

On the other hand, the study on the molecular element proposed in Japanese Patent Laid-Open No. 2006-351623 (pp. 11 to 15, FIGS. 1 to 5) is just beginning, and possibly the progress of the study can provide a molecular element having various novel characteristics.

The present invention is made in view of these circumstances, and an object thereof is to provide a resistive element having unique electrical conductivity, a neuron element that includes an input part formed of a simple circuit and has excellent learning ability, and a neural network information processing device employing the neuron element.

Specifically, the present invention relates to a first resistive element that exhibits hysteresis in which the resistance of a resistor decreases if a voltage is applied to both sides of the resistor to make a current pass through the resistor, and relates to a second resistive element in which the resistance of a resistor gradually increases if voltage application to both sides of the resistor is kept absent.

Furthermore, the present invention relates to a first neuron element that is a neuron element having an input part that receives a plurality of input signals and, in response to the input signals, creates weighted signals as the products of the input signals and connection weights corresponding to the input signals, an addition part that obtains the total sum of the plurality of weighted signals, and an output part that outputs an output signal as a function of the total sum, and being characterized in that

the first resistive element is used as an element that creates the weighted signal from the input signal in the input part, and the resistance of the resistive element decreases due to a current flowing through the resistive element in reception of the input signal, and as a result a current flowing through the resistive element in reception of a subsequent input signal comes to flow more easily, and thereby a learning effect is obtained.

In addition, the present invention relates to a second neuron element that is characterized in that

the second resistive element is used as an element that creates the weighted signal from the input signal in the input part, and

the resistance of the resistive element gradually increases if reception of the input signal is absent.

Moreover, the present invention relates to a neural network information processing device formed by connecting a plurality of the first or second neuron elements.

The first resistive element of the present invention is a unique resistive element that exhibits hysteresis in which the resistance of a resistor decreases if a voltage is applied to both sides of the resistor to make a current pass through the resistor. Furthermore, the second resistive element is a unique resistive element in which the resistance of a resistor gradually increases if voltage application to both sides of the resistor is kept absent. As the cause of such a phenomenon, it can be speculated that the molecules in the resistor assume arrangement or alignment that facilitates current flow if current passage is allowed whereas the arrangement or alignment of the molecules is disturbed due to thermal motion if current passage is kept absent. However, this has not yet been made clear.

The hysteresis exhibited by the first resistive element can be compared to history recording. Furthermore, if the phenomenon exhibited by the second resistive element is combined with the hysteresis, it is equivalent to erasing (forgetting) of the history recording. Conventionally, there are various kinds of elements that can record the peak value or a value at a certain time, of a voltage or the like, by a single element. However, as described above, an element that can record a history such as repetition by a single element does not exist. The first resistive element and the second resistive element are the first elements that can record the history such as repetition.

In the first neuron element of the present invention, the first resistive element is used as an element that creates the weighted signal from the input signal in the input part. Therefore, the resistance of the resistive element decreases due to a current flowing through the resistive element in reception of the input signal, and as a result a current flowing through the resistive element in reception of a subsequent input signal comes to flow more easily, and thereby a learning

effect is obtained. Furthermore, in the second neuron element of the present invention, the second resistive element is used as an element that creates the weighted signal from the input signal in the input part. Therefore, the resistance of the resistive element gradually increases if reception of the input signal is absent. They are one of the most effective application examples of the first resistive element and the second resistive element, and are neuron elements that can realize the learning function possessed by the creature's brain, "the more the brain is used, the wiser the brain becomes," with a simple configuration. Furthermore, if these neuron elements are used, an autonomous learning function can be automatically given to an interconnected neural network such as a Hopfield network.

Moreover, the neural network information processing device of the present invention is formed by connecting a plurality of the above-described neuron elements of the present invention, and thus can exert excellent learning ability with a simple configuration.

Brief Description of Drawings

[FIG. 1]
FIG. 1(a) is an explanatory diagram of a functional molecular element that is a resistive element based on Embodiment 1 of the present invention, and FIG. 1(b) is an explanatory diagram showing the alignment structure of a π-conjugated molecule as the first layer of an array structural body (absorbed molecule).

[FIG. 2]
FIG. 2(a) is a structural formula showing one example of the molecular structure of a π-conjugated molecule for forming an array structural body based on Embodiment 1 of the present invention, and FIG. 2(b) is a schematic diagram for showing the three-dimensional structure of a substantially-discotic backbone part of the π-conjugated molecule.

[FIG. 3]
FIGS. 3(a) and 3(b) are structural formulas showing the molecular structures of a π-conjugated molecule and a solvent used in fabrication of the functional molecular element based on Embodiment 1 of the present invention.

[FIG. 4]
FIG. 4 is a graph showing the current-voltage characteristic of the functional molecular element based on Embodiment 1 of the present invention.

[FIG. 5]
FIG. 5 is graphs obtained by examining change in the current flowing through the functional molecular element based on Embodiment 1 of the present invention over time with variation in the applied voltage.

[FIG. 6]
FIG. 6 is an explanatory diagram showing the configuration of an input part and an addition part in a neuron element based on Embodiment 2 of the present invention.

[FIG. 7]
FIG. 7 is a schematic explanatory diagram showing the configuration of a nerve cell.

[FIG. 8]
FIG. 8(a) is a schematic explanatory diagram showing the functions of a neuron element in a model manner, and FIGS. 8(b-1) and 8(b-2) are graphs showing examples of a conventional output function.

[FIG. 9]
FIG. 9(a) is an explanatory diagram showing an example of a hierarchical neural network and FIG. 9(b) is an explanatory diagram showing an example of an interconnected neural network.

[FIG. 10]
FIG. 10 is an explanatory diagram showing one example of the configuration of an input part and an addition part in a conventional neuron element.

Best Modes for Carrying Out the Invention

In the first resistive element of the present invention, it is preferable that the resistance of the resistor gradually increase toward a resistance value possessed before current application if voltage application is stopped and current passage is kept absent. As described above, if the hysteresis is compared to history recording, this phenomenon is equivalent to erasing (forgetting) of the history recording. When both are available, the learning function similar to that of the creature's brain is exerted. It is not that the gradual erasing of the history recording involves no disadvantageous aspect. However, if long-term, stable memory is necessary, a memory element can be used in combination only for this part.

In the first and second resistive elements of the present invention, it is preferable that the resistor be a functional

molecular element composed of an organic functional molecule. Because there are an extremely wide variety of organic functional molecules, a proper functional molecule can be easily found.

In this case, in the functional molecule, it is preferable that

opposed electrodes obtained by disposing a plurality of electrodes opposed to each other be formed, and a π-conjugated molecule in which a side chain part is coupled to a backbone part having a substantially-planar structure formed of a π-conjugated system be absorbed by the electrode at the side chain part, and thereby an absorbed molecule that is so disposed that the substantially-planar structure of the backbone part is in substantially parallel to the opposed electrodes be formed for each of the opposed electrodes, and

a structural body composed of at least the absorbed molecule and the opposed electrodes have a function to allow a current to flow in a direction intersecting with the substantially-planar structure depending on a voltage applied between the opposed electrodes.

In a conventional functional molecular element, the contact resistance between the functional molecule and the electrode is high, and as a result the element performance is frequently restricted. In contrast, according to the functional molecular element, the π-conjugated molecule is formed with coupling of a side chain part to a backbone part having a substantially-planar structure formed of a π-conjugated system. Thus, in the absorbed molecule, the substantially-planar structure of the backbone part is disposed in substantially parallel to the electrode due to absorption of the side chain part by the electrode, and the absorbed molecule can assume a structure in tight contact with the electrode. As a result, the electrical interaction between the π-electrons forming the π-conjugated system and the electrode becomes favorable, and the contact resistance between the π-conjugated molecule and the electrode is suppressed to low resistance.

The functional molecular element is a functional molecule element in which a structural body composed of at least the absorbed molecule and the opposed electrodes have a function to allow a current to flow in a direction intersecting with the substantially-planar structure depending on a bias voltage applied between the opposed electrodes. In this case, the contact resistance at the opposed electrodes is suppressed to low resistance as described above, and the influence thereof is small. Thus, the current-voltage characteristic of the functional molecular element depends mainly on the electrical characteristic of an assembly of the absorbed molecule, the π-conjugated molecule, and so on, existing between the opposed electrodes.

In this case, in the functional molecular element, it is preferable that an array structural body arising from stacking of the same kind of π-conjugated molecules as the absorbed molecule or/and another kind of π-conjugated molecules along one direction over the backbone part of the absorbed molecule by intermolecular π-π stacking at the backbone part be formed as a part of the structural body between the opposed electrodes, and the structural body have a function to allow a current to flow in the stacking direction of the array structural body. If the array structural body is formed by the intermolecular π-π stacking as described above, a current can be made to effectively flow in the stacking direction of the array structural body due to the interaction between π-electrodes.

Furthermore, it is preferable that the side chain part of the π-conjugated molecule have a flexible structure in the functional molecule. If this is employed, the side chain part comes to be absorbed on the electrode more easily, and the resistance between the π-conjugated molecule and the electrode can be decreased. It is preferable that the side chain part be formed of an alkyl group, an alkoxy group, a silanyl group, or an aromatic ring to which an alkyl group, an alkoxy group, or a silanyl group is coupled.

In addition, it is preferable that the π-conjugated molecule and/or another kind of π-conjugated molecule be a complex of a central metal ion and a linear tetrapyrrole derivative in the functional molecule. In particular, the array structural body composed of a complex including a zinc ion as the central metal ion exhibits the ON and OFF switching characteristic with favorable electric conductivity based on the presence and absence of an electric field acting thereon. Thus, a transistor and so on can be fabricated. As the central metal ion, besides the zinc ion, a metal ion of a transition element or a typical element, such as a copper ion or a nickel ion, can be used.

In this case, it is preferable that at least the π-conjugated molecule be a biladienone derivative represented by General formula (1).

General formula (1):

[Chemical 1]

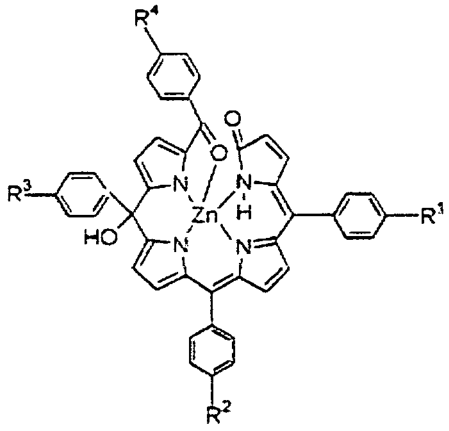

(in General formula (1), $R^1$, $R^2$, $R^3$, and $R^4$ are the same or different alkyl groups that are independent of each other and each have a carbon number of 3 to 12.)

$R^1$, $R^2$, $R^3$, and $R^4$ may be any as long as the number of carbon atoms is 3 to 12. For example, $-C_{10}H_{21}$ and $-C_{12}H_{25}$ are cited. If a side chain having such a number of carbon atoms is employed, the π-conjugated molecule is fixed in such a state as to be favorably aligned on the electrode without being crystallized. In addition, synthesis is also easy. On the other hand, if the number of carbon atoms is one or two, the π-conjugated molecule is easily crystallized, and comes not to exhibit liquid-crystal-like properties and to cause an alignment defect easily. In addition, if the number of carbon atoms is 13 or larger, the alignment is difficult on the contrary, and synthesis is also difficult.

In the first neuron element of the present invention, it is preferable that, if reception of the input signal is absent, the resistance of the resistive element gradually increase toward a resistance value possessed before the learning effect is obtained and the learning effect be gradually lost. As described above, this is equivalent to the disappearance of the learning effect. The learning effect is accumulated if it is necessary, and the learning effect is lost if it becomes unnecessary. When both are available, the learning function similar to that of the creature's brain is exerted. If long-term, stable holding of the learning effect is necessary, a memory element can be used in combination only for this part.

It is preferable that the neural network information processing device of the present invention be formed as a hierarchical neural network information processing device in which the neuron elements are disposed in a plurality of layers and the neuron elements are coupled to each other between the layers. Alternatively, it is preferable that it be formed as an interconnected neural network information processing device in which all of the neuron elements are coupled to each other to form one layer.

Next, preferred embodiments of the present invention will be described below more specifically under reference to the drawings.

Embodiment 1

In Embodiment 1, an example of a resistive element formed of a functional molecular element will be mainly described as an example relating to claims 1 to 10.

FIG. 2(a) is a structural formula showing one example of the molecular structure of a π-conjugated molecule 1 included in an array structural body 4 in Embodiment 1. FIG. 2(b) is a schematic diagram for showing mainly the three-dimensional structure of a substantially-discotic backbone part 2 of the π-conjugated molecule 1 shown in FIG. 2(a). In FIG. 2(b), a metal ion M, nitrogen atoms, carbon atoms, and oxygen atoms in the backbone part 2 are indicated as spheres, whereas diagrammatic representation of hydrogen atoms is omitted. Side chain parts 3 are shown very briefly with abbreviation.

As shown in FIGS. 2(a) and 2(b), the basic structure of the backbone part 2 of the π-conjugated molecule 1 is biladienone (specifically, 4, 9-biladien-1-one). Biladienone is one kind of linear tetrapyrrole having a structure equivalent to an opened porphyrin ring. The backbone part 2 forms a porphyrin-like rigid substantially-planar structure due to the π-conjugated system. However, two carbonyl groups (C=O groups) are formed at the cleavage part of the opened porphyrin ring and they are opposed to each other. Therefore, the shape of the backbone part 2 is slightly twisted from the planar shape and thus is a helical substantially-discotic shape with left flexibility. M at the center part of the substantially-discotic structure denotes a metal ion such as a zinc ion.

The π-conjugated molecule 1 is formed with coupling of the side chain parts 3 formed of a p-alkylphenyl group to the above-described backbone part 2. The side chain part 3 forms a flexible chain structure due to internal rotation about the C-C axis.

FIG. 1(a) is a schematic diagram showing the structure of a functional molecular element 11 based on Embodiment 1 in a model manner. FIG. 1(b) is an explanatory diagram showing the alignment structure with respect to an electrode, of the π-conjugated molecule 1 as the first layer of the array structural body 4 of the molecular element 11 (an absorbed molecular 9 absorbed by the electrode surface).

FIG. 1(a) shows the functional molecular element 11 in which the array structural body 4 having a column shape is formed by arranging the π-conjugated molecules 1 having the substantially-discotic backbone part 2 along one direction between two electrodes 5 and 6 that have a nano-scale gap and are composed of e.g. gold in such a way that the disk surfaces of the π-conjugated molecules 1 are aligned in parallel to the surfaces of the electrodes 5 and 6.

Conventionally, the following fact is known. Specifically, if an array structural body is formed by using π-conjugated molecules having a rigid discotic or substantially-discotic backbone part like the π-conjugated molecules 1, the discotic or substantially-discotic backbone parts of the respective molecules are so stacked as to be in parallel to each other (be opposed to each other in a face-to-face manner) due to π-π interaction, and pi electrons are delocalized between the stacked backbone parts. In particular, in the case of a molecule (discotic liquid crystal or the like) having a long alkyl group side chain (with a carbon number of six or more), the π-conjugated molecules are stacked in a column manner and can exhibit high electric conductivity in the stacking direction (refer to Y. Shimizu, T. Higashiyama and T. Fuchita, "Photoconduction of a mesogenic long-chain tetraphenylporphyrin in a symmetrical sandwich-type cell", Thin Solid Films, 331 (1998), 279-284.).

Furthermore, it is said that a metal ion may be coordinated near the center of the discotic or substantially-discotic backbone part (refer to Y. Shimizu, "Phtoconductivity of Discotic Liquid Crystals: a Mesogenic Long-Chain Tetraphenylporphyrin and Its Metal Complexes", Molecular Crystals and Liquid Crystals, 370 (2001), 83-91, S. T. Trzaska, H-F. Hsu and T. M. Swager, "Cooperative Chirality in Columnar Liquid Crystals: Studies of Fluxional Octahedral Metallomesogens", J. Am. Chem. Soc., 121 (1999), 4518-4519, and Yo Shimizu, "Columnar Ekishou Sono Tayouna Bunshikouzou to Bunshikan Sougosayou", Ekishou, 6 (2002), 147-159.).

As one example of the functions of the array structural body formed by π-π stacking of substantially-discotic π-conjugated molecules such as linear tetrapyrrole as described above, a function as a pipe (channel chain) that allows the passage of the flow of electrons in the stacking direction is possible. The diameter of the current path is larger compared with general electrically-conductive chain molecules and the flow of a large amount of current is possible. Studies to utilize the array structural body as an electron channel of a solar cell are active.

However, in the case of using the above-described array structural body as an electrical conductor, it is necessary that, as shown in FIG. 1(a), the stacking direction of the array structural body 4 is matched with the direction in which current flow is to be made (direction coupling the electrode 5 and the electrode 6) and the array structural body 4 is so disposed that the ends of the array structural body 4 are in tight contact with the surfaces of the electrodes 5 and 6 so that the contact resistance at the electrodes 5 and 6 may be low.

If a molecule having no side chain is used as the π-conjugated molecule for forming the array structural body, it is impossible to control the alignment of the π-conjugated molecules with respect to the electrode surfaces and the stacking direction of the molecules because there is no group having the effect to control the absorption state on the electrode surfaces and make the disk surfaces be selectively aligned in parallel to the electrode surfaces.

Therefore, in the present embodiment, the π-conjugated molecule 1 having the flexible side chain parts 3 shown in FIG. 2(a) is used as the π-conjugated molecule. Furthermore, a solution of the π-conjugated molecule 1 in which the concentration of the π-conjugated molecule 1 is properly adjusted is prepared and this solution is deposited on the electrode 5 or 6 by a coating method such as a casting method, followed by evaporation of the solvent from the solution. Thereafter, annealing treatment is performed if necessary, and the absorbed molecule 9 as the above-described absorbed molecule is so disposed as to be brought into tight contact with the surface of the electrode 5 or 6, and the π-conjugated molecules are stacked over this absorbed molecule 9 by π-π stacking, so that the array structural body 4 is formed. There is no particular limitation on the stacked π-conjugated molecules, except for that they are molecules that can form the π-π stacking for the π-conjugated molecule 1. Although an example in which the same kind of molecules as the π-conjugated molecule 1 are stacked is shown in FIG. 1(a), the above-described another kind of n-conjugated molecules may be stacked.

In this case, it is important that, as shown in FIG. 1(b), the flexible side chain parts 3 of the n-conjugated molecule 1 (the absorbed molecule 9) forming the first layer of the array structural body 4 are absorbed by the surface of the electrode 5 (or 6) and as a result the substantially-disk surface of the backbone part 2 is so fixed as to be in almost parallel to and in tight contact with the surface of the electrode 5 (or 6). Thus, n-electrons of the backbone part 2 can be delocalized on the electrode, and the contact resistance across the interface between the array structural body 4 and the electrode 5 (or 6) can be suppressed to low resistance.

Furthermore, the stacking direction of the molecular layers as the second and subsequent layers of the array

structural body 4 is so controlled by the π-π interaction that, on the basis of the substantially-disk surface of the backbone part 2 of the absorbed molecule 9 disposed in parallel to the electrode surface, the substantially-disk surface of the backbone part of the upper molecular layer overlaps on the substantially-disk surface of the backbone part of the lower molecular layer in parallel. The array structural body 4 allows a current to effectively flow in the stacking direction due to the interaction between n-electrons.

In the above-described manner, the robust functional molecular element 11 can be obtained in which the contact resistance across the interface with the electrode is very low and the stacking direction of the array structural body 4 (the current flow direction) is controlled.

<Fabrication of Functional Molecular Element 11>

FIG. 3(a) is a structural formula of the π-conjugated molecule 1 used in the fabrication of the functional molecular element 11. FIG. 3(b) is a structural formula of tetrahydrofuran (THF), which is a solvent used in the fabrication of the functional molecular element 11. The n-conjugated molecule shown in FIG. 3(a) is a zinc complex of a biladienone derivative having, as the flexible side chain part 3, a phenyl group to which a dodecyl group $-C_{12}H_{25}$ is coupled in para-position.

The functional molecular element 11 is fabricated in the following manner. First, the n-conjugated molecule 1 is formed by making zinc acetate react with biladienone containing no central metal ion. This is dissolved in THF to fabricate a solution with a concentration of 2 mM. On the other hand, a chromium layer having a thickness of 5 nm and a gold layer having a thickness of 20 nm are stacked and formed over a substrate of silicon or the like, and the opposed electrodes 5 and 6 having a gap of 16 nm therebetween are formed by electron beam lithography. Subsequently, 1 μL of the solution is dropped at the position of the gap between the opposed electrodes, and the solution is kept as it is for seven days. Thereafter, the THF solvent molecules are evaporated under vacuum at a room temperature to be removed from the functional molecular element 11.

<Electrical Measurement>

Before electrical measurement of the functional molecular element 11, a bias voltage in the range of -2 V to +2 V is applied to the functional molecular element 11 for two hours or longer as pre-treatment for making the n-conjugated molecule 1 assume a predetermined alignment state. On this occasion, to lead the π-conjugated molecule 1 to the predetermined alignment state, it is important to increase the applied bias voltage in increments of 50 mV. Thus, initially a bias voltage of -2 V is applied, and the bias voltage is increased by 50 mV per one step, so that a bias voltage of +2 V is obtained after 80 steps. Thereafter, the current-voltage characteristic of the functional molecular element 11 is measured at a room temperature.

FIG. 4 is a graph showing the current-voltage characteristic exhibited by the functional molecular element 11 based on the present embodiment of the present invention at a room temperature. FIG. 4 shows graph (a) obtained before the current flow, graph (b) obtained after the above-described voltage in the range of -2 V to +2 V continues to be applied for 20 minutes, and graph (c) obtained after the above-described voltage in the range of -2 V to +2 V continues to be applied for 60 minutes. The graphs show that the resistance of the functional molecular element 11 decreases due to the continuation of the current flow by the voltage application.

FIG. 5 is graphs obtained by examining change in the current flowing through the functional molecular element 11 over time with variation in the applied voltage. The voltages given to the respective graphs are the applied voltages (V). The following tendencies can be found from FIG. 5.

(1) The absolute value of the current starts to rise with time after the elapse of a certain time.
(2) The current value after the rise is asymmetrical with respect to the polarity of the voltage.
(3) The time dependence of the current value after the rize is substantially linear. However, a component that increases and decreases with time is added thereon.

Embodiment 2

In Embodiment 2, an example of a neuron element including a functional molecular element as the above-described resistive element in an input part will be mainly described as an example relating to claims 11 to 13.

FIG. 6 is an explanatory diagram showing the configuration of the input part and an addition part in the neuron element based on Embodiment 2 of the present invention.

As shown in FIG. 6, the functional molecular elements 11 equivalent to synapses are provided in an input part 10. In response to the respective input signals xi (i = 1 to n) from other neuron elements, the functional molecular elements 11 create weighted signals wixi (i = 1 to n) as the products of the input signals xi and connection weights wi (i = 1 to n)

corresponding to the inputs. The connection weight wi corresponds to the signal transmission characteristic of the synapse.

Specifically, the input signal xi (i = 1 to n) is applied to one electrode of the functional molecular element 11 as a voltage signal. The other electrode of the functional molecular element 11 is connected to the inverting input terminal of an OP amp (operational amplifier) 21 in the addition part 20 and is kept at the ground potential effectively. As a result, the current in inverse proportion to the resistance of the functional molecular element 11 is sent to the addition part 20 as a current signal equivalent to the weighed signal wixi.

The resistance of the functional molecular element 11 decreases due to the current flowing through the functional molecular element 11 in reception of the input signal. As a result, the current flowing through the functional molecular element 11 in reception of the subsequent input signal comes to flow more easily, and thereby a learning effect is obtained. Furthermore, if reception of the input signal is absent, the resistance of the functional molecular element 11 gradually increases, so that the learning effect is obtained. Due to the accumulation and disappearance of this learning, the resistance of the functional molecular element 11 is always kept at the optimum value at the time.

If e.g. an interconnected neural network such as a Hopfield network is formed by using this neuron element 50, an autonomous learning function can be automatically given, and the optimum value is given as the pattern of the current flowing in the Hopfield network.

As shown in FIG. 6, the addition part 20 is a current-voltage conversion circuit formed of the OP amp (operational amplifier) 21. The output currents from the respective input circuits 11 in the input part 10 are collected into the inverting input terminal of the OP amp 21 and flow from a feedback resistor 22. Thereby, a voltage signal corresponding to the total sum (net value) X defined by the following equation is output to an output circuit.

$$X = w1x1 + w2x2 + \cdots + wnxn$$

Although omitted in FIG. 6, the output part is formed of an OP amp or the like and formed with e.g. a circuit that can generate a sigmoid function as the output.

The present invention has been described above based on the embodiments. It should be obvious that the present invention is not limited by these examples at all but can be accordingly changed without departing from the gist of the invention.

Industrial Applicability

The present invention can contribute to enhancement in the performance of a neural network information processing device applied to pattern recognition by parallel distributed processing, combinatorial optimization problem and inverse matrix calculation involving many variables, associative memory, and various fields in which autonomous learning is necessary, at all of which the von Neumann computer is no good.

## Claims

1. A resistive element that exhibits hysteresis in which resistance of a resistor decreases if a voltage is applied to both sides of the resistor to make a current pass through the resistor.

2. The resistive element according to claim 1, wherein the resistance of the resistor gradually increases toward a resistance value possessed before current application if voltage application is stopped and current passage is kept absent.

3. A resistive element wherein resistance of a resistor gradually increases if voltage application to both sides of the resistor is kept absent.

4. The resistive element according to any one of claims 1 to 3, wherein the resistor is a functional molecular element composed of an organic functional molecule.

5. The resistive element according to claim 4, wherein
in the functional molecular element,
opposed electrodes obtained by disposing a plurality of electrodes opposed to each other are formed, and a n-conjugated molecule in which a side chain part is coupled to a backbone part having a substantially-planar structure

formed of a n-conjugated system is absorbed by the electrode at the side chain part, and thereby an absorbed molecule that is so disposed that the substantially-planar structure of the backbone part is in substantially parallel to the opposed electrodes is formed for each of the opposed electrodes, and
a structural body composed of at least the absorbed molecule and the opposed electrodes has a function to allow a current to flow in a direction intersecting with the substantially-planar structure depending on an applied voltage applied between the opposed electrodes.

**6.** The resistive element according to claim 5, wherein
in the functional molecular element,
an array structural body arising from stacking of the same kind of n-conjugated molecules as the absorbed molecule or/and another kind of π-conjugated molecules along one direction over the backbone part of the absorbed molecule by intermolecular π-π stacking at the backbone part is formed as a part of the structural body between the opposed electrodes, and
the structural body has a function to allow a current to flow in a stacking direction of the array structural body.

**7.** The resistive element according to claim 5, wherein the side chain part of the π-conjugated molecule has a flexible structure in the functional molecular element.

**8.** The resistive element according to claim 7, wherein the side chain part of the n-conjugated molecule is formed of an alkyl group, an alkoxy group, a silanyl group, or an aromatic ring to which an alkyl group, an alkoxy group, or a silanyl group is coupled.

**9.** The resistive element according to claim 5, wherein the n-conjugated molecule is a complex of a central metal ion and a linear tetrapyrrole derivative in the functional molecular element.

**10.** The resistive element according to claim 9, wherein at least the n-conjugated molecule is a biladienone derivative represented by General formula (1).
General formula (1):

[Chemical 1]

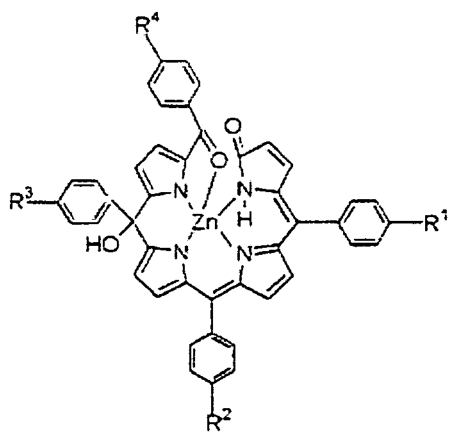

(in General formula (1), $R^1$, $R^2$, $R^3$, and $R^4$ are the same or different alkyl groups that are independent of each other and each have a carbon number of 3 to 12.)

**11.** A neuron element having an input part that receives a plurality of input signals and, in response to the input signals, creates weighted signals as products of the input signals and connection weights corresponding to the input signals, an addition part that obtains a total sum of the plurality of weighted signals, and an output part that outputs an output signal as a function of the total sum, the neuron element being **characterized in that**
the resistive element according to any one of claims 1 to 10 is used as an element that creates the weighted signal from the input signal in the input part, and
resistance of the resistive element decreases due to a current flowing through the resistive element in reception of

the input signal, and as a result a current flowing through the resistive element in reception of a subsequent input signal comes to flow more easily, and thereby a learning effect is obtained.

**12.** The neuron element according to claim 11, wherein, if reception of the input signal is absent, the resistance of the resistive element gradually increases toward a resistance value possessed before the learning effect is obtained and the learning effect is gradually lost.

**13.** A neuron element having an input part that receives a plurality of input signals and, in response to the input signals, creates weighted signals as products of the input signals and connection weights corresponding to the input signals, an addition part that obtains a total sum of the plurality of weighted signals, and an output part that outputs an output signal as a function of the total sum, the neuron element being **characterized in that**
the resistive element according to claim 3 is used as an element that creates the weighted signal from the input signal in the input part, and
the resistance of the resistive element gradually increases if reception of the input signal is absent.

**14.** A neural network information processing device formed by connecting a plurality of the neuron elements according to any one of claims 11 to 13.

**15.** The neural network information processing device according to claim 14, formed as a hierarchical neural network information processing device in which the neuron elements are disposed in a plurality of layers and the neuron elements are coupled to each other between the layers.

**16.** The neural network information processing device according to claim 14, formed as an interconnected neural network information processing device in which all of the neuron elements are coupled to each other to form one layer.

FIG. 1

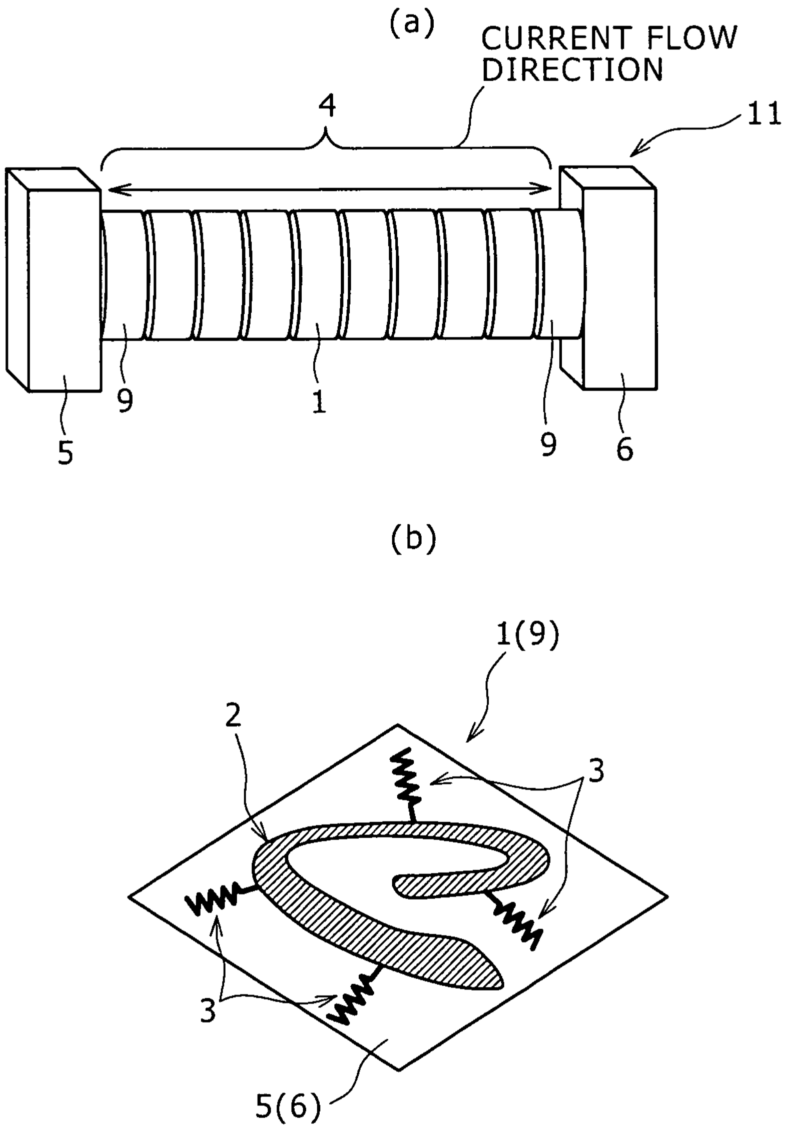

# FIG. 2

(a)

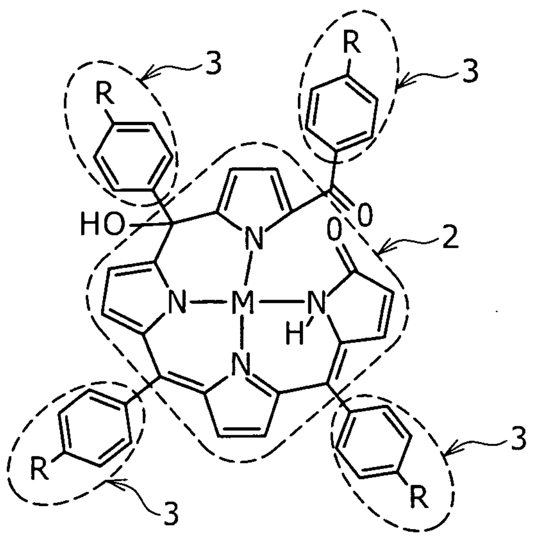

(b)

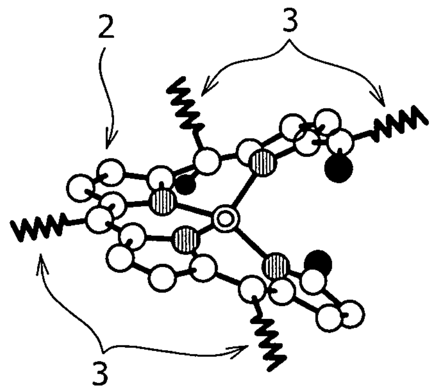


◎ DENOTES METAL ION M
◍ DENOTES NITROGEN ATOM
○ DENOTES CARBON ATOM
● DENOTES OXYGEN ATOM

# FIG. 3

(a)

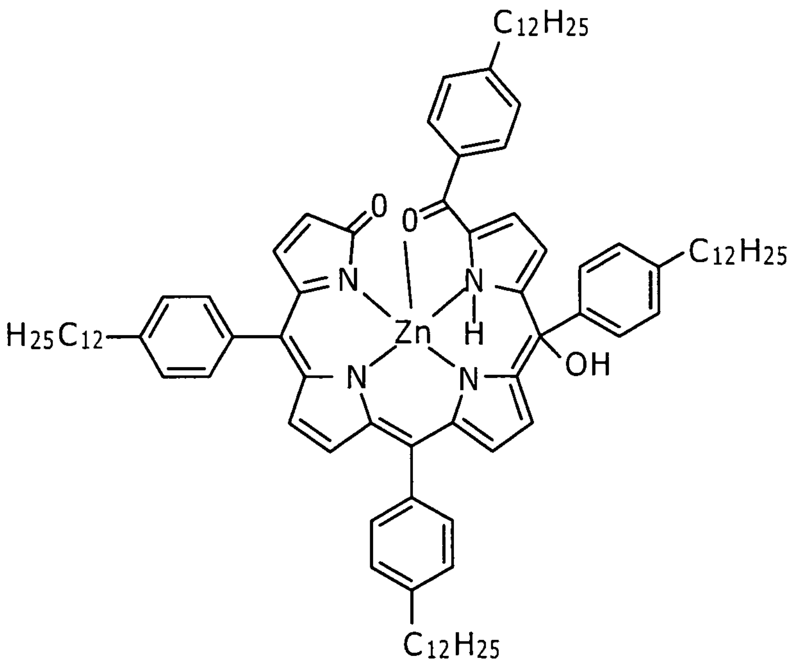

(b) THF

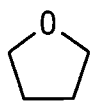

FIG. 4

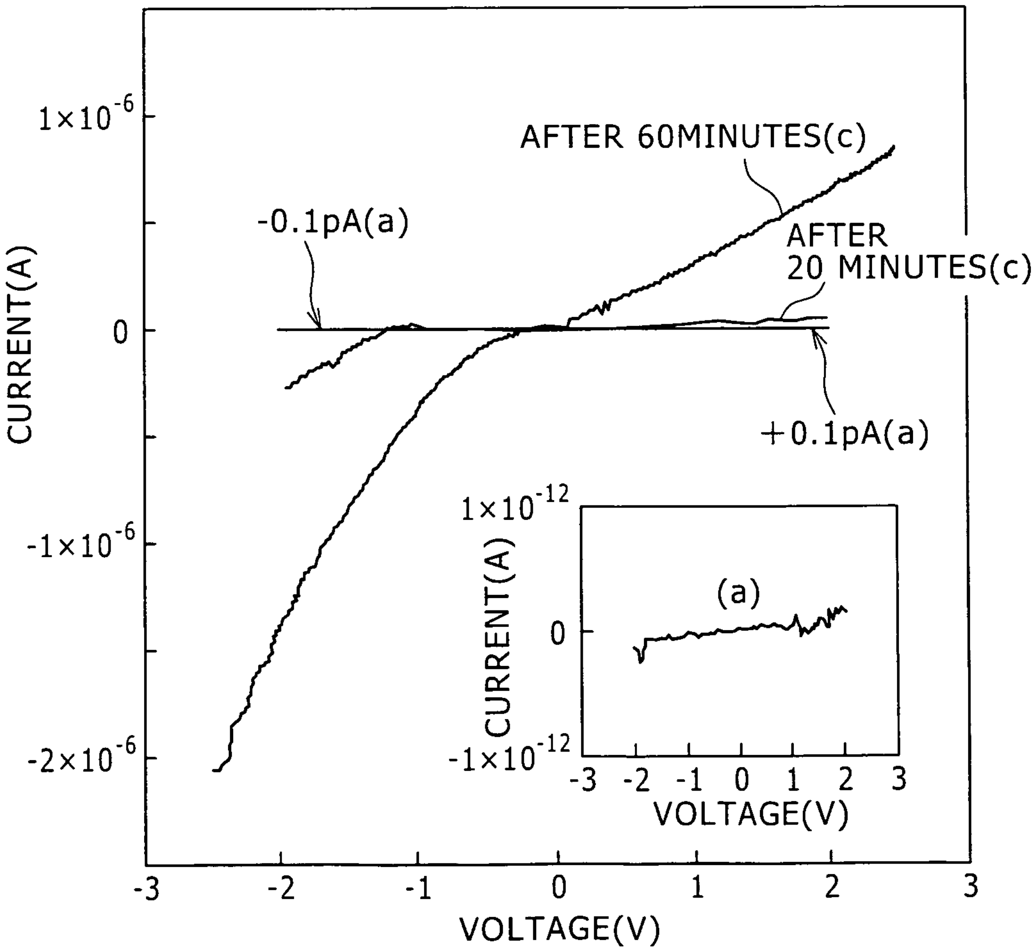
1×10-6
0
-1×10-6
-2×10-6
CURRENT(A)
-3
-2
-1
0
1
2
3
VOLTAGE(V)
AFTER 60MINUTES(c)
-0.1pA(a)
AFTER
20 MINUTES(c)
+0.1pA(a)
1×10-12
0
-1×10-12
CURRENT(A)
(a)
-3 -2 -1 0 1 2 3
VOLTAGE(V)

FIG. 5

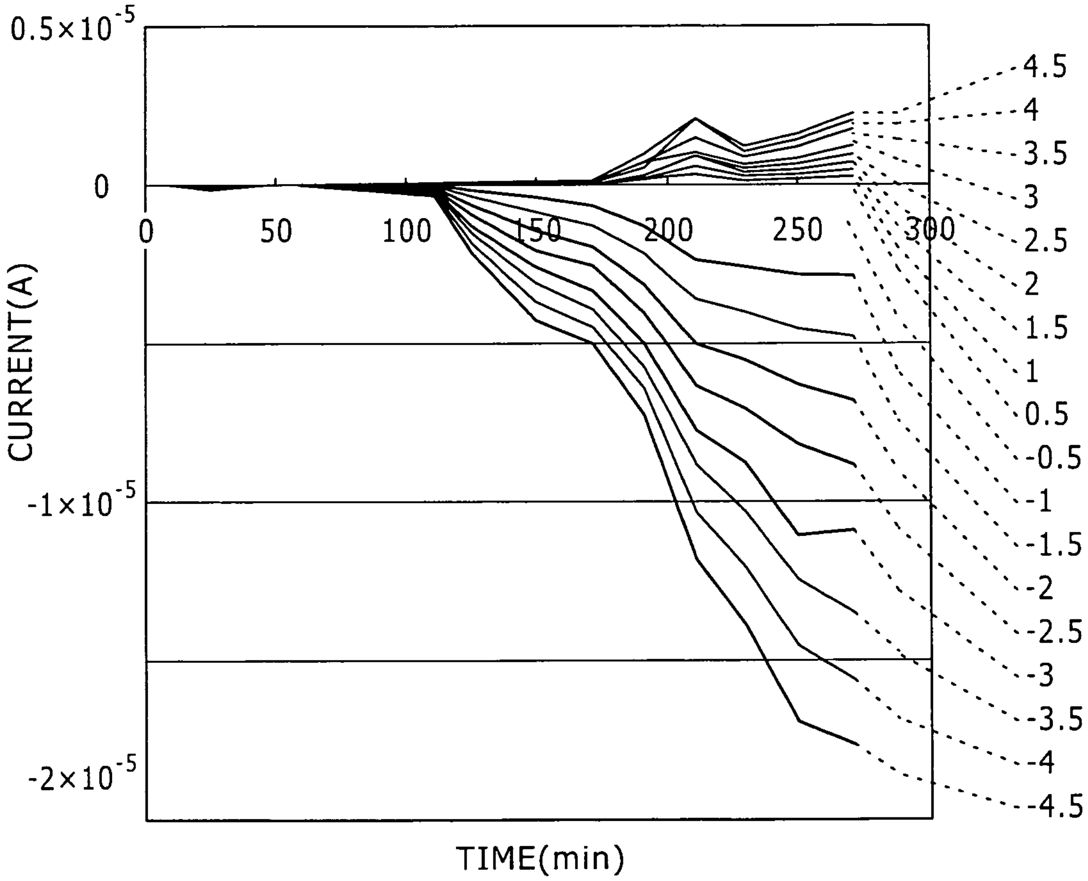
0.5×10^-5
0
-1×10^-5
-2×10^-5
CURRENT(A)
0
50
100
150
200
250
300
TIME(min)
4.5
4
3.5
3
2.5
2
1.5
1
0.5
-0.5
-1
-1.5
-2
-2.5
-3
-3.5
-4
-4.5

FIG. 6

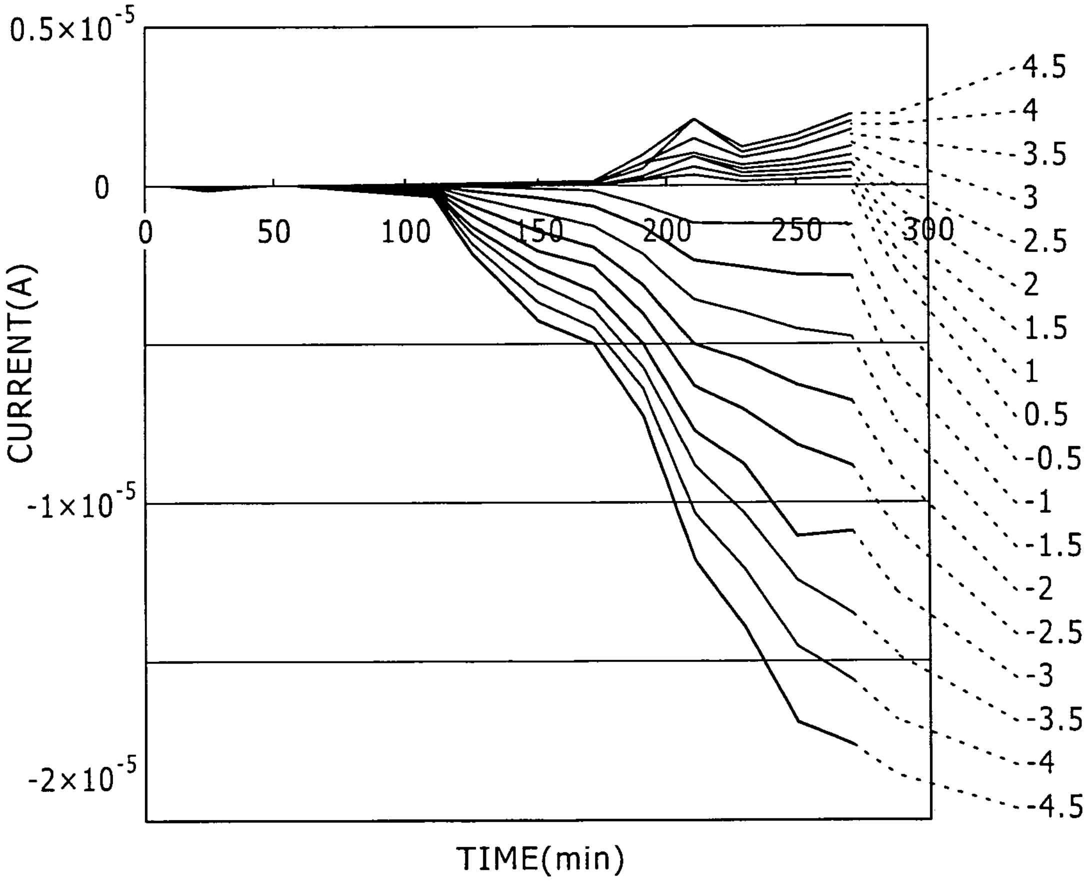
0.5×10-5
0
-1×10-5
-2×10-5
CURRENT(A)
0
50
100
150
200
250
300
TIME(min)
4.5
4
3.5
3
2.5
2
1.5
1
0.5
-0.5
-1
-1.5
-2
-2.5
-3
-3.5
-4
-4.5

FIG. 7

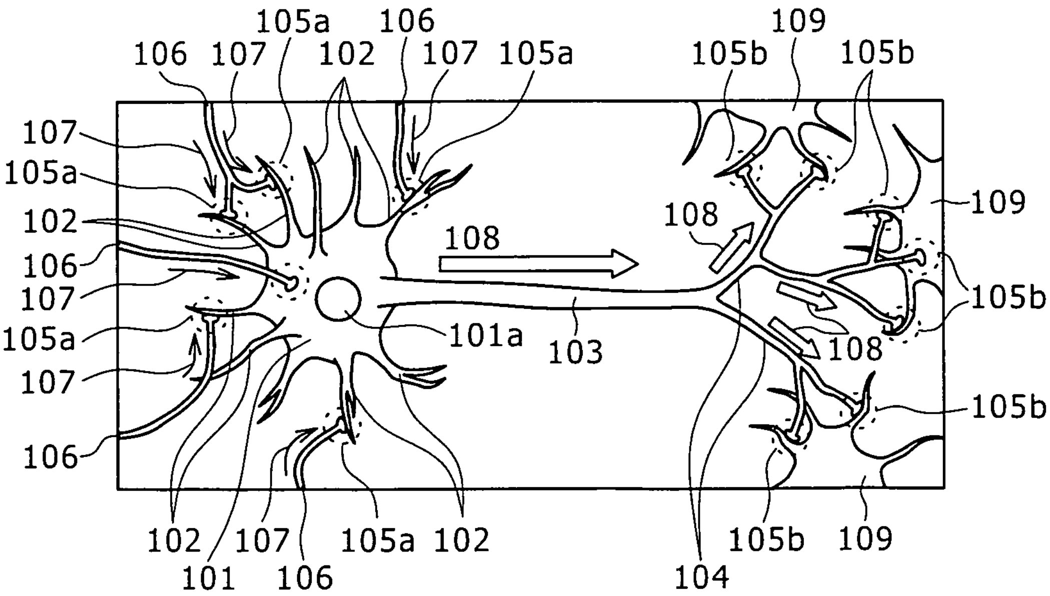
105a
106
106
107
102
107
105a
107
105a
102
106
107
105a
107
106
108
101a
103
102
107
105a
102
101
106
109
105b
105b
109
108
105b
108
105b
105b
109
104

# F I G . 8

(a)

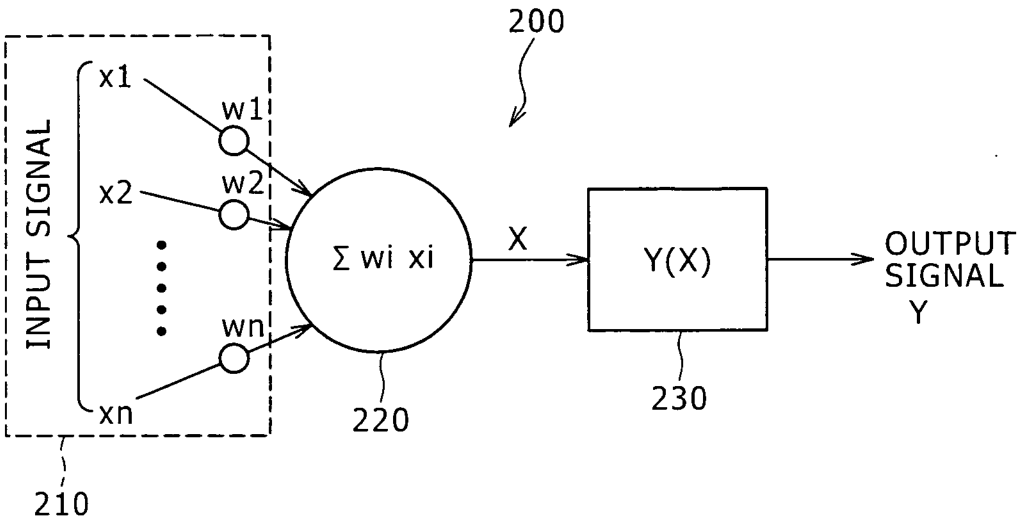
200
INPUT SIGNAL
x1
x2
xn
w1
w2
wn
Σ wi xi
X
Y(X)
OUTPUT
SIGNAL
Y
210
220
230

(b-1)

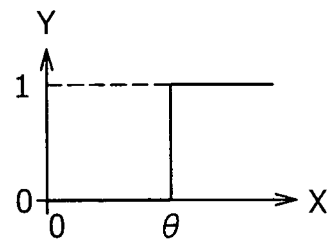
Y
1
0
X
0
θ

(b-2)

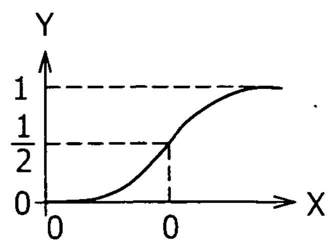
Y
1
1/2
0
X
0
0

FIG.9

(a)

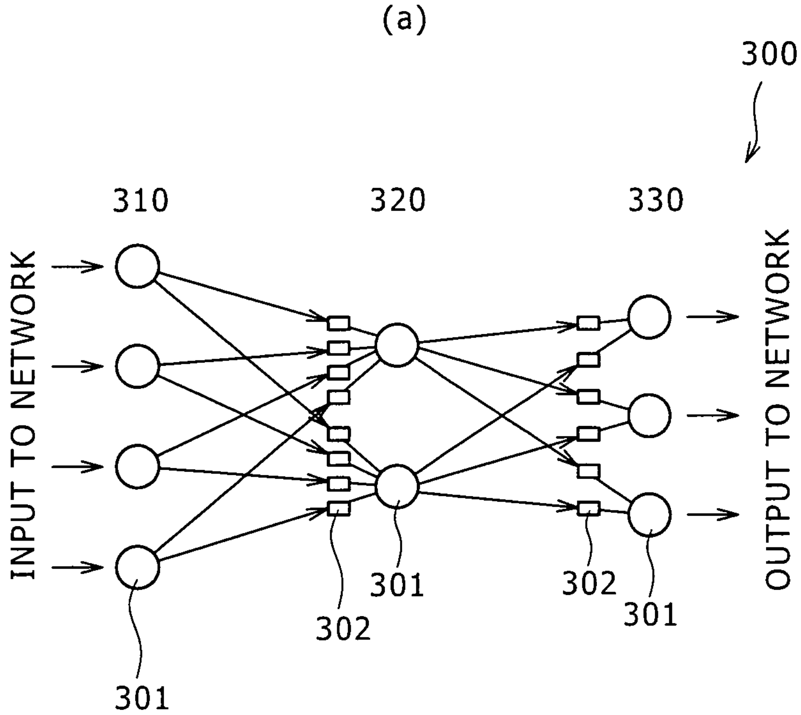
300
310
320
330
INPUT TO NETWORK
OUTPUT TO NETWORK
301
302
301
302
301

(b)

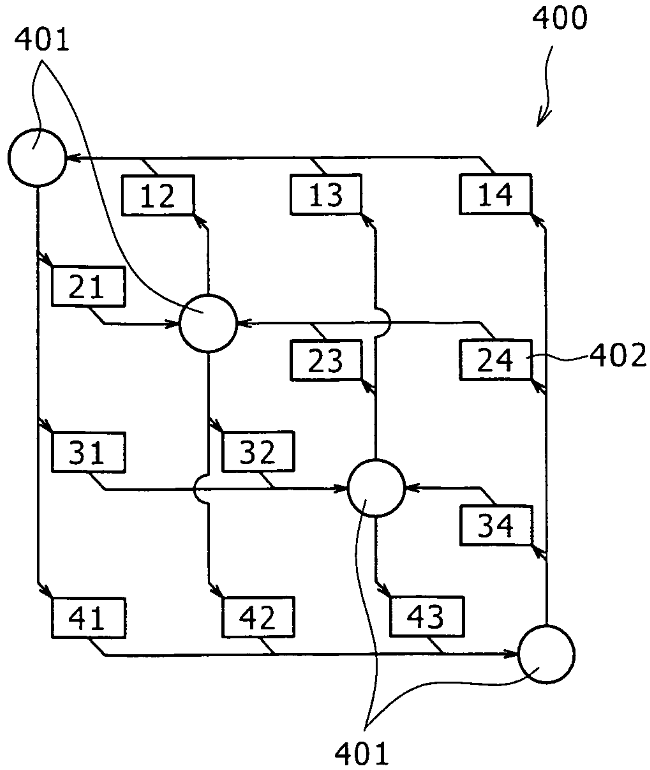
400
401
12
13
14
21
23
24
402
31
32
34
41
42
43
401

FIG.10

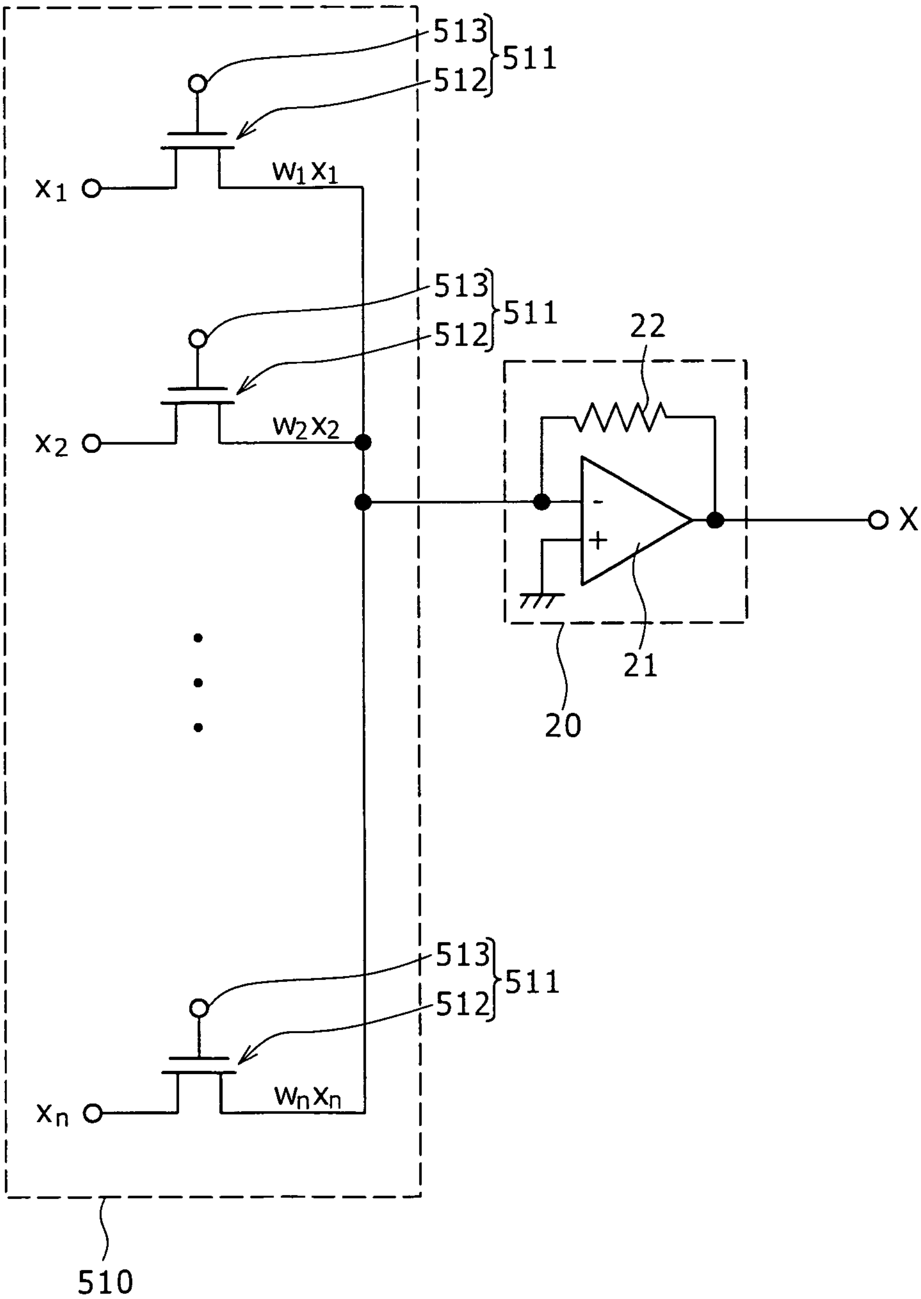
513
511
512
$x_1$
$w_1x_1$
513
511
512
22
$x_2$
$w_2x_2$
-
+
X
21
20
513
511
512
$x_n$
$w_nx_n$
510

**INTERNATIONAL SEARCH REPORT**

International application No. PCT/JP2008/059720

A. CLASSIFICATION OF SUBJECT MATTER
*H01L21/822*(2006.01)i, *G06N3/063*(2006.01)i, *H01L27/04*(2006.01)i, *H01L45/00*(2006.01)i, *H01L49/00*(2006.01)i, *H01L51/00*(2006.01)i, *H01L51/30*(2006.01)i

According to International Patent Classification (IPC) or to both national classification and IPC

B. FIELDS SEARCHED

Minimum documentation searched (classification system followed by classification symbols)
H01L21/822, G06N3/063, H01L27/04, H01L45/00, H01L49/00, H01L51/00, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 3-255668 A (Matsushita Research Institute Tokyo, Inc.), 14 November, 1991 (14.11.91), Full text & US 5223750 A & EP 460903 A2 | 1-4,11-16 |
| X | JP 6-20074 A (Canon Inc.), 28 January, 1994 (28.01.94), Full text (Family: none) | 1,4,11,14-16 |
| X | JP 2007-004514 A (Elpida Memory, Inc.), 11 January, 2007 (11.01.07), Full text & US 2006/0294034 A1 | 1,11,14-16 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>20 June, 2008 (20.06.08) | Date of mailing of the international search report<br>01 July, 2008 (01.07.08) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2008/059720

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-351623 A (Sony Corp.), 28 December, 2006 (28.12.06), Claim 13; Par. No. [0059] & US 2006/0278868 A1 & EP 1734594 A2 & KR 10-2006-0129947 A & CN 1881643 A | 5-10 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004221553 A
- JP 2006351623 A
- JP HEI3144785 B
- JP HEI512466 B

### Non-patent literature cited in the description


- **Norio Baba ; Fumio Kojima ; Seiichi Ozawa.** Neural Net no Kiso to Ouyou. Kyoritsu Shuppan Co., Ltd, 1994
- **Takeo Miyazawa.** *Jissen Neural Net,* September 1988, vol. 12, 237
- *JISSEN NEURAL NET,* April 1989, vol. 13, 341
- **Y. Shimizu ; T. Higashiyama ; T. Fuchita.** Photoconduction of a mesogenic long-chain tetraphenylporphyrin in a symmetrical sandwich-type cell. *Thin Solid Films,* 1998, vol. 331, 279-284
- **Y. Shimizu.** Phtoconductivity of Discotic Liquid Crystals: a Mesogenic Long-Chain Tetraphenylporphyrin and Its Metal Complexes. *Molecular Crystals and Liquid Crystals,* 2001, vol. 370, 83-91
- **S. T. Trzaska ; H-F. Hsu ; T. M. Swager.** Cooperative Chirality in Columnar Liquid Crystals: Studies of Fluxional Octahedral Metallomesogens. *J. Am. Chem. Soc.,* 1999, vol. 121, 4518-4519
- **Yo Shimizu.** Columnar Ekishou Sono Tayouna Bunshikouzou to Bunshikan Sougosayou. *Ekishou,* 2002, vol. 6, 147-159